Europäisches Patentamt

European Patent Office

Office européen des brevets

(19)

(11) Veröffentlichungsnummer: **0 058 761**
**B1**

# (12) EUROPÄISCHE PATENTSCHRIFT

(45) Veröffentlichungstag der Patentschrift:
09.04.86

(21) Anmeldenummer: 81109281.6

(22) Anmeldetag: 29.10.81

(51) Int. Cl.⁴: **H 01 L 23/48,** H 05 K 1/02,
H 01 L 21/60

(54) Systemträger für mit Kunststoff umhüllte elektrische Bauelemente.

(30) Priorität: 19.02.81 DE 3106193

(43) Veröffentlichungstag der Anmeldung:
01.09.82 Patentblatt 82/35

(45) Bekanntmachung des Hinweises auf die Patenterteilung:
09.04.86 Patentblatt 86/15

(84) Benannte Vertragsstaaten:
DE FR GB IT

(56) Entgegenhaltungen:
US - A - 4 027 326

L'Aluminium, Tome 2, Editions Eyrolles, Paris Ve, 1964,
S. 683 und 684

(73) Patentinhaber: Siemens Aktiengesellschaft, Berlin und
München Wittelsbacherplatz 2, D-8000 München 2 (DE)

(72) Erfinder: Ullrich, Hans, Dr. Dipl.-Phys.,
Platanenstrasse 3, D-8021 Taufkirchen (DE)
Erfinder: Freitag, Theodor, Dipl.-Phys.,
Ostpreussenstrasse 6, D-8012 Ottobrunn (DE)

## Beschreibung

Die Erfindung betrifft einen Systemträger für mit Kunststoff umhüllte elektrische Bauelemente, insbesondere Halbleiter-Bauelemente, bei dem das Beuelement auf dem Systemträger angebracht ist.

Übliche Systemträger für Kunststoffbauformen bestehen aus Eisen-Nickel beziehungsweise aus Kupfer-Legierungen und sind vollständig oder teilweise mit einer Edelmetallschicht aus Silber oder Gold überzogen.

Systemträger für mit Kunststoff umhüllte elektrische Bauelemente, die selbst auf dem Systemträger befestigt sind, sollten die folgenden Eigenschaften besitzen:

Im Bereich der Anschlußfinger um die Insel muß der Systemträger eine kontaktierbare Oberfläche besitzen.

Der Systemträger sollte weiterhin gute Wärmeleitungseigenschaften bei einer hohen elektrischen Leitfähigkeit aufweisen und ausreichend mechanisch fest beziehungsweise stabil sein.

Infolge der hohen Stückzahlen in der Fertigung elektrischer Bauelemente müssen für eine wirtschaftliche Verwertbarkeit die Systemträgerkosten äußerst gering sein, was insbesondere auch für den Aufwand bei der Herstellung gilt.

Auch sollte der Kunststoff gut am Systemträger der Bauform haften, um so eine lange Betriebsdauer zu gewährleisten.

Schließlich sollten noch die einen Teil des Systemträgers bildenden Außenanschlußfinger der fertigen Bauform eine gut lötbare Oberfläche besitzen, um so an eine äußere Schaltung auf einfache Weise anschließbar zu sein.

Schon seit längerer Zeit werden Systemträger gesucht, die alle oben angegebenen Eigenschaften erfüllen und dabei dennoch kostengünstig sind.

Bisher werden für Systemträger als Materialien beispielsweise Vacon (FeNiCo), Alloy 42 (FeNi), CuFe, CuZr, Tombak (CuZn) und so weiter mit vollständig oder partiell aufgebrachter Edelmetalloberfläche aus Gold oder Silber verwendet. Infolge der gerade in letzter Zeit stark gestiegenen Kosten für Edelmetalle und des hohen Aufwandes für ausgebildete Arbeitskräfte sollte daher ein Systemträger geschaffen werden, der sich mit wesentlich geringeren Kosten herstellen läßt, wobei sich diese Kosten bei derzeitigen Systemträgern aus Grundmaterial-, Stanz-, Oberfächenvergütungs- und Edelmetallkosten zusammensetzen.

Aus der Druckschrift US—A—4 027 326 ist ein Systemträger bekannt, der aus einem der Metalle: Cu, Ni, Fe oder Co, oder aus einer legierung eines oder mehrerer diese Metalle besteht, und mit einer Oberflächen beschichtung versehen ist, die eine schwammartige, microporöse Struktur aufweist und aus einem der Metalle: Au, Pd, Ag, Al und Cu, oder aus einer legierung wenigstens zweier dieser Metalle besteht.

Es ist daher Aufgabe der Erfindung, eii Systemträger anzugeben, der bei möglichst ringen Kosten alle oben angegebenen Forder gen besser oder wenigstens gleich als die ü chen Systemträger erfüllt.

Diese Aufgabe wird erfindungsgemäß dadu gelöst, daß der Systemträger keine Oberfläch beschichtung aufweist und ganz aus ei Aluminiumlegierung besteht.

Als Aluminiumlegierung ist beispielsw AlMgSi geeignet.

Durch die Verwendung von Aluminiumle rungen für Systemträger entfallen zunächst Kosten für die Oberflächenvergütung sowie Edelmetallkosten, da — wie zahlreiche Versu gezeigt haben — sich Aluminiumlegierungen rekt mit dem herkömmlichen Drahtkontaktier- fahren kontaktieren lassen. Außerdem hal Aluminiumlegierungen bekanntlich ein wes lich geringeres spezifisches Gewicht als beispi weise CuFe, so daß bei gleichem Gewicht e dreimal so viele Systemträger als bisher gest werden können. Zusätzlich ergeben sich b Versand einer gleichen Menge von System gern an andere Fertigungsstandorte wesent geringere Frachtkosten.

Die Erfindung bietet aber nicht nur wesentli Vorteile hinsichtlich der Fertigungskosten: V mehr sind auch die reinen Materialkosten Aluminiumlegierungen im allgemeinen gerin als die von Kupferlegierungen, wenn diese sten auf die gleiche Gewichtseinheit bezo werden.

Die elektrische und die thermische Leitfähig von Aluminiumlegierungen ist zwar etwas ge ger als die entsprechenden Leitfähigkeiten Kupferlegierungen; sie ist aber noch wesent besser als die Leitfähigkeit von Vacon oder A 42.

Nachfolgend wird die Erfindung an Hand Zeichnung näher erläutert. Es zeigen:

    Fig. 1 einen Systemträger in Draufsicht,
    Fig. 2 eine fertige Bauform in Seitensicht,
    Fig. 3 die Bauform der Fig. 2 in Draufsicht, u
    Fig. 4 eine Vordersicht der Bauform der Fi und 3.

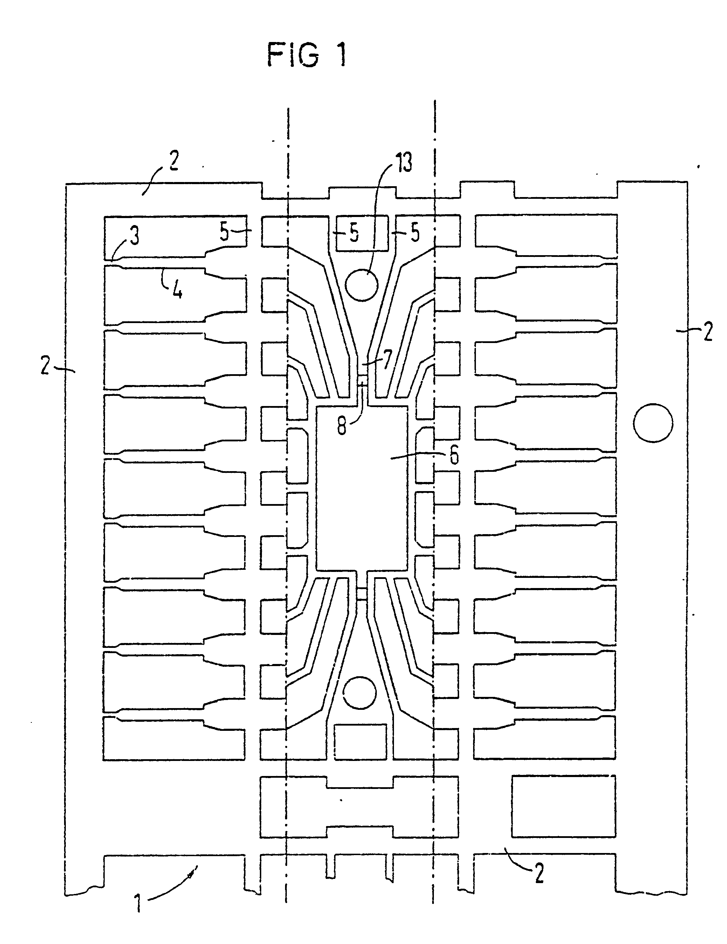

In Fig. 1 ist ein Systemträger 1 gezeigt, der einen AlMgSi-Legierung besteht. Dieser Syst träger 1 besteht aus einem Rahmen 2, der ü Stege 3 mit Fingern 4 verbunden ist, die unter ander wiederum durch Stege 5 verbunden si Diese Finger 4 erstrecken sich bis nahe zu ein Mittenteil 6, auf den das Halbleitersystem auf bracht wird. Dieser Mittenteil 6 ist seinerseits ü zwei Stege 7 mit dem Rahmen 2 verbunden. Stege 7 sind an einer Stelle 8 jeweils et abgewinkelt, so daß die Oberfläche des Mitt teils 6 etwas tiefer als die Ebene des Rahmer und der Finger 3 liegt.

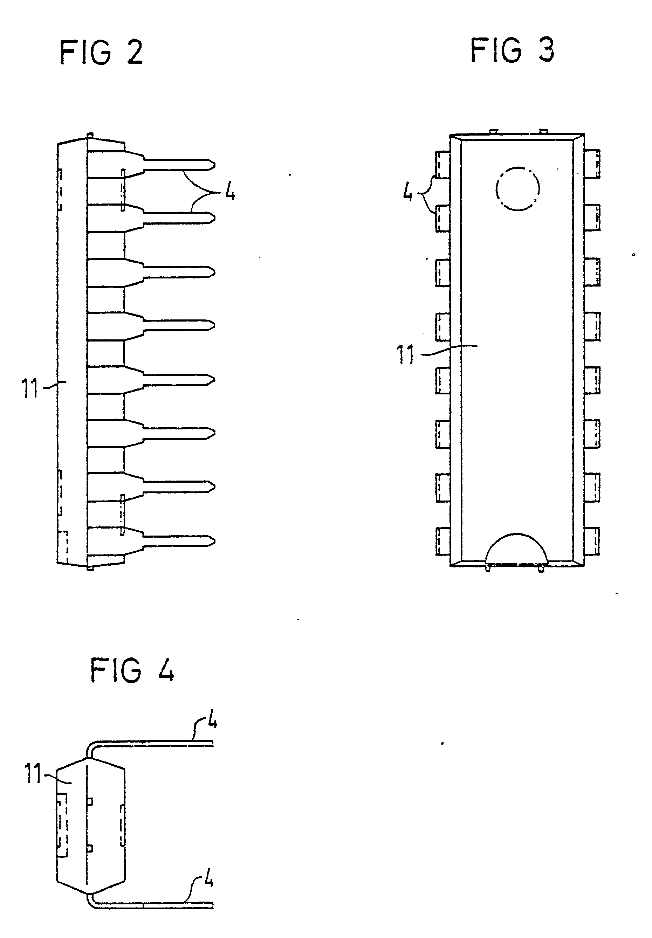

Nach Anbringen eines Halbleitersystems dem Mittenteil 6 (Insel) und Verspritzen der ordnung mit Kunststoff 11 werden die Steg und 5 durchtrennt und die Finger 4 senkrech die Zeichenebene abgebogen, wodurch die in Fig. 2 bis 4 gezeigte Anordnung entsteht.

Die Erfindung ermöglicht einen einfach herstellbaren Systemträger, bei dem keine galvanische Behandlung oder partielle Versilberung oder Vergoldung erforderlich ist. Zudem ist der erfindungsgemäße Systemträger mit geringerem Materialaufwand herstellbar und besitzt dennoch wenigstens gleich vorteilhafte Eigenschaften wie bestehende Systemträger.

## Patentansprüche

1. Systemträger für mit Kunststoff umhüllte elektrische Bauelemente, insbesondere Halbleiter-Bauelemente, bei dem das Bauelement auf dem Systemträger angebracht ist, dadurch gekennzeichnet, daß der Systemträger keine Oberflächenbeschichtung aufweist und ganz aus einer Aluminiumlegierung besteht.

2. Systemträger nach Anspruch 1, dadurch gekennzeichnet, daß er ganz aus der Aluminiumlegierung AlMgSi besteht.

## Revendications

1. Embase formant support pour composants électriques enrobés de plastique, en particulier pour composants à semi-conducteurs, le composant étant disposé sur l'embase, caractérisée en ce que l'embase ne présente pas de revêtement de surface et est entièrement en alliage d'aluminium.

2. Embase selon la revendication 1, caractérisée en ce qu'elle est entièrement en alliage d'aluminium AlMgSi.

## Claims

1. A lead frame for resin-encapsulated electrical components, in particular semiconductor components, in which the component is mounted on the lead frame, characterised in that the lead frame does not have any surface coating and consists wholly of an aluminium alloy.

2. A lead frame as claimed in Claim 1, characterised in that it consists wholly of the aluminium alloy AlMgSi.

# FIG 1

0 058 761

FIG 2

FIG 3

FIG 4

3